# EUROPEAN PATENT APPLICATION

(11) **EP 2 076 109 A2**
(43) Date of publication of application: **01.07.2009**
(21) Application number: 08254083.2
(22) Date of filing: 19.12.2008
(51) Int. Cl.: H05K 5/02

(54) **Display device**

(30) Priority: 25.12.2007 JP 2007332694
(71) Applicant: Orion Electric Co., Ltd, Echizen-shi, Fukui 915-8555 (JP)
(72) Inventor: Kataoka, Yusuke , Orion Electric Co. Ltd., Echizen-city, Fukui 915-8555 (JP); Tanikawa, Schinichi , Orion Electric Co. Ltd., Echizen-city, Fukui 915-8555 (JP); Maeno, Takanori , Orion Electric Co. Ltd., Echizen-city, Fukui 915-8555 (JP)
(74) Representative: Paget, Hugh Charles Edward

(57) **Abstract**

A cabinet-fixing locking nail 27a and a locking stopper 28 are formed at a fixing unit 20 which is integrally attached to a button portion 4. The button portion 4 is fixed to a back cabinet 2b through the fixing unit 20, by locking the cabinet-fixing locking nail 27a and the locking stopper 28 to the back cabinet 2b. A power circuit board 5a is clipped to circuit board engagement slits 15, 30 which are guide grooves formed at the fixing unit 20 and the button portion 4, and the power circuit board 5a is locked by a first circuit board locking nail 31 which is formed at the back cabinet 2b to be fixed. The power circuit board 5a and the button portion 4 can be readily fixed only by a locking unit such as the cabinet-fixing locking nail 27a, the locking stopper 28, the circuit board engagement slits 15, 30, the first circuit board locking nail 31 and the like without using screw.

## Description

### BACKGROUND OF THE INVENTION

### Field of the invention

The present invention relates to a display device which displays an image consisting of characters, figures, color and the like. More specifically, the present invention relates to a display device where main members such as button portions (which are housed in a cabinet constructing an appearance of a display device such as a liquid crystal television receiver or the like) can be readily held by a short time.

### Description of the Related Art

Recently, about a liquid crystal image display device having a small depth such as a liquid crystal TV or a plasma display device or the like, it has been proposed that button portions (operation buttons) by which the switching of channels or the adjustment of a sound magnitude and the like become capable are arranged at an upper surface, a side surface or a lower surface of a housing of the image display device. The space in the housing of the flat-screen image display device of this kind is limited to be small. In the case where members such as the button portions and the like are attached, the button portions and the like are screw-cramped by using screws made of metal. Therefore, it becomes necessary for a troublesome screw-cramping operation to attach the members such as the button portions in the housing (which has a narrow space) by the screw. According to JP-A-2007-114566 which is a related art about this, a screw is inserted through a screw hole which is formed at the operation button and the tip side of the screw which is inserted is screwed together with a screw hole which is formed at a front cabinet so that the operation button is screw-cramped.

In the image display device where the button portion is fixed by the screw in the background art, the operation for rotating the screw by multiple times in order to fix the button portion is necessary when the screw is used to fix the button portion. In this case, the attachment operation of the member cannot be readily made by a one-touch feeling. Moreover, when the screw made of the metal which is generally used is used, the cost of the metal material will become high.

### SUMMARY OF THE INVENTION

In view of the above-described disadvantage, it is an object of the present invention to provide a display device where an attachment operation of an inner construction member as a main member can be readily performed by a short time without using a screw and the manufacture efficiency can be improved while the cost can be lowered.

According to one aspect of the present invention, a display device which includes a display panel in a housing having a relatively small depth in comparison with a height and a width thereof is provided with an operation portion which is arranged at the housing and protrudes from a plurality of through holes to the external, a first holding unit which is arranged at the operation portion to hold one end of a circuit board, and a second holding unit which is arranged at the housing to hold the other end of the circuit board. The circuit board which is held by the first holding unit and the second holding unit is substantially parallel to the display panel.

Preferably, the housing is constructed by fitting an opening portion which is provided at a front cabinet and an opening portion which is provided at a back cabinet respectively.

More preferably, the circuit board is provided with a switch which interlocks with a press operation of the operation portion at least.

More preferably, the operation portion is constructed of a button portion where a pressing portion protruding to the external is integrally formed, and a fixing unit where a locking unit for fitting the button portion to the back cabinet is formed.

According to the above-described display device, the circuit board where the switch and the like are arranged is held by the first holding unit of the operation portion and the second holding unit arranged at the housing. Therefore, the circuit board can be fixed without using a screw.

More preferably, the first holding unit is a guide groove which extends to a rear side of the operation portion to be formed, and the one end of the circuit board is clipped by the guide groove.

Accordingly, the circuit board can be clipped by the guide groove as the first holding unit of the operation portion, and the circuit board can be held by the second holding unit which is arranged at the housing. Thus, the circuit board can be fixed without using the screw.

More preferably, the second holding unit is constructed of a single circuit board locking nail or a plurality of circuit board locking nails which extend from an inner surface side of the back cabinet to the opening portion thereof to be formed, and the other end of the circuit board is locked by the circuit board locking nail.

Accordingly, the circuit board can be clipped by the guide groove as the first holding unit of the operation portion, and the circuit board can be locked by the circuit board locking nail as the second holding unit which is arranged at the housing. Thus, the circuit board can be fixed without using the screw.

More preferably, the display device is further provided with a third holding unit for holding an inner construction member at the back cabinet.

Accordingly, the inner construction members which are housed in the back cabinet can be held by the third holding unit. Thus, the inner construction members can be fixed at a predetermined position in the back cabinet without using the screw.

More preferably, the inner construction member includes a speaker and a light receiving board.

Accordingly, the speaker and the light receiving board as the inner construction member can be held by the third holding unit. Thus, the speaker and the light receiving board can be fixed at a predetermined position in the back cabinet without using a screw.

More preferably, the third holding unit is a holder for locking the inner construction member. A boss portion which extends from the inner surface side to a side of the opening portion is formed at the back cabinet. An engagement hole is formed at an edge portion of the back cabinet which is in the vicinity of the boss portion. A cylinder hole where the boss portion is engaged and a nail portion which is engaged with the engagement hole are formed at the holder.

Accordingly, the inner construction member such as the speaker and the light receiving board and the like is locked by the holder as the third holding unit. The cylinder hole of the holder is engaged with the boss portion of the back cabinet, and the nail portion formed at the holder is engaged with the engagement hole. The inner construction member such as the speaker, the light receiving board and the like can be fixed to the back cabinet through the holder without using the screw.

According to the present invention, when the speaker and the various circuit boards such as a light receiving board or the like as the inner construction members which are the main members of the display device are attached to the back cabinet which is the housing, the speaker and the various circuit boards such as the light receiving board and the like can be fixed by the holding unit and the locking unit (being not the fixing by the screw) without using the screw. Therefore, the troublesome screw-fitting operation can be relieved. Moreover, because the screw made of the metal is not used, the cost due to the use of the metal material can be reduced. Furthermore, the screw screwing working becomes unnecessary, so that the working time spent in assembling the inner construction members can be shortened and the manufacture efficiency of the display device can be improved.

### BRIEF DESCRIPTION OF THE DRAWINGS

Other objects, features and advantages of the present invention will become more apparent from the following detailed description made with reference to the accompanying drawings, in which:
FIG. 1 is a perspective view which shows an image display device according to an embodiment of the present invention;
FIG. 2 is an exploded perspective view showing a state where a front cabinet of the image display device is detached;
FIG. 3 is a perspective view showing a state where a liquid crystal panel is detached from a back cabinet;
FIG. 4 is a perspective view which shows an operation portion where a button portion and a fixing unit are integrated;
FIG. 5 is a perspective view which shows the button portion;
FIG. 6 is a perspective view which shows the fixing unit;
FIG. 7 is an enlarged cross sectional view which shows a main portion of the display device;
FIG. 8 is an exploded perspective view which shows a speaker and a speaker holder to which the speaker is attached;
FIG. 9 is a perspective view which shows a state where the speaker is attached to the speaker holder.
FIG. 10 is a perspective view which shows the back cabinet;
FIG. 11 is a perspective view which shows a state where the button portion is attached to the back cabinet by the fixing unit;
FIG. 12 is a perspective view which shows a state where the circuit board is attached to the back cabinet;
FIG. 13 is a perspective view which shows a state where the speaker is attached to the back cabinet; and
FIG. 14 is an enlarged perspective view which shows a main portion of the back cabinet.

### DESCRIPTION OF THE PREFERRED EMBODIMENT

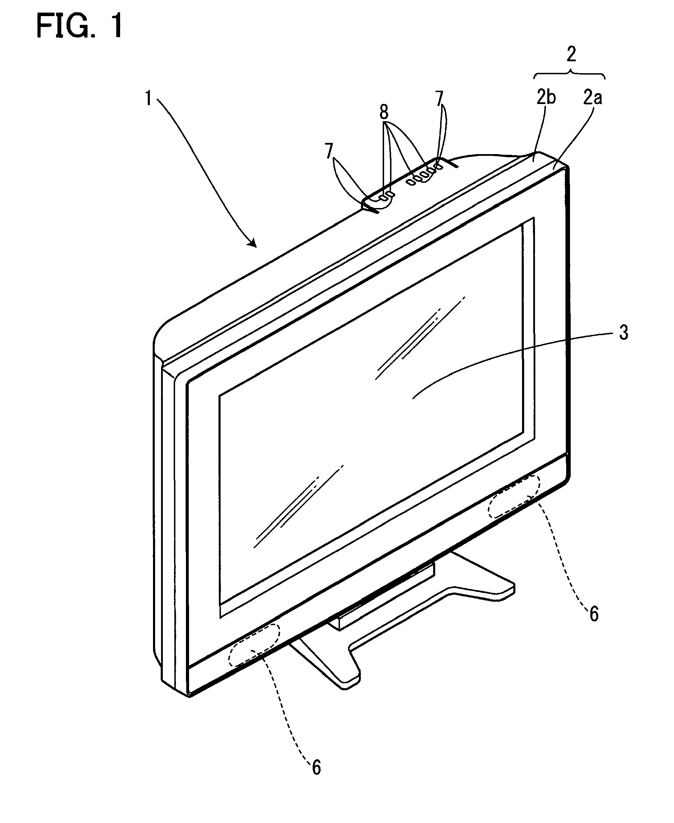

A preferred embodiment of the present invention will be described with reference to FIGS. 1-14. Needless to say, the present invention can be also readily suitable for the matter having the other structure than that described in the embodiment in a range which does not depart from the purport of the present invention.

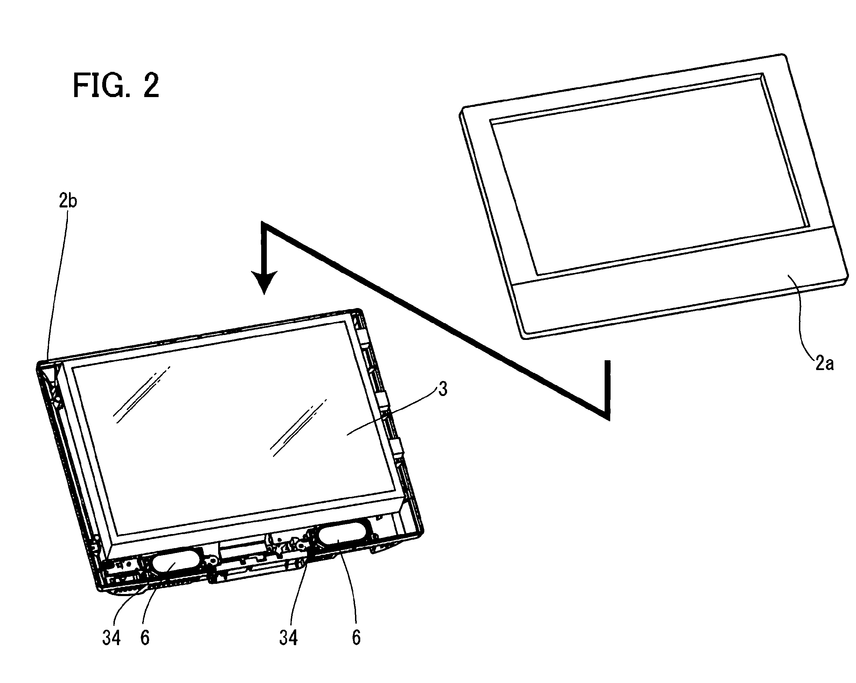

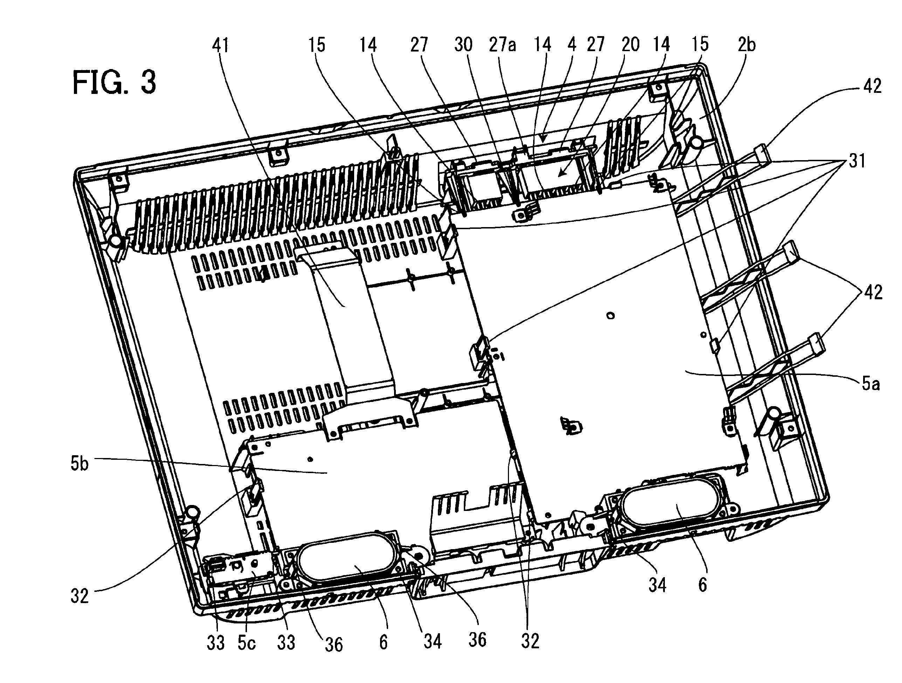

FIG. 1 is a perspective view which shows an image display device according to this embodiment. FIG. 2 is an exploded perspective view showing a state where a front cabinet of the image display device is detached. FIG. 3 is a perspective view showing a state where a liquid crystal panel is detached from a back cabinet.

One example of the display device shown in FIGS. 1-3 and the like is a display device 1 of a flat-screen liquid crystal television receiver or the like which has a small depth. A housing 2 which is made of a resin and constructs an appearance of the display device 1 is constructed of two divisions including a front cabinet 2a and a back cabinet 2b. All of inner construction members such as a liquid crystal panel 3 (display panel) which displays the image, a button portion 4, various circuit boards 5a, 5b, 5c (which are arranged substantially parallel to the liquid crystal panel 3) and a speaker 6 are housed in the back cabinet 2b, but not the front cabinet 2a. Moreover, a through hole 7 is formed at an upper surface of the back cabinet 2b. A button 8 which is formed at the button portion 4 is inserted through the through hole 7, and arranged to protrude to an outer side of an upper portion of the back cabinet 2b. Furthermore, the front cabinet 2a and the back cabinet 2b are arranged to be integrated in such a state where opening portions which are respectively provided at the front cabinet 2a and the back cabinet 2b are faced to each other. The inner portion of the housing 2 has a relatively small depth as compared with a height and a width thereof.

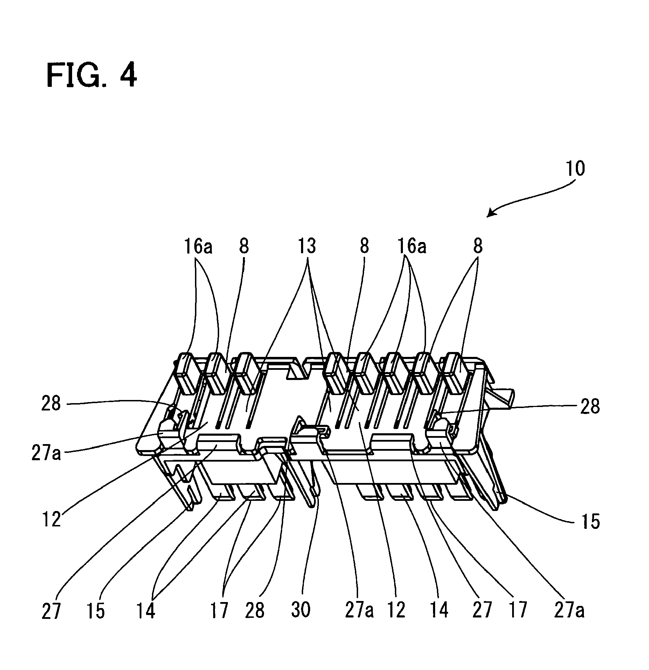

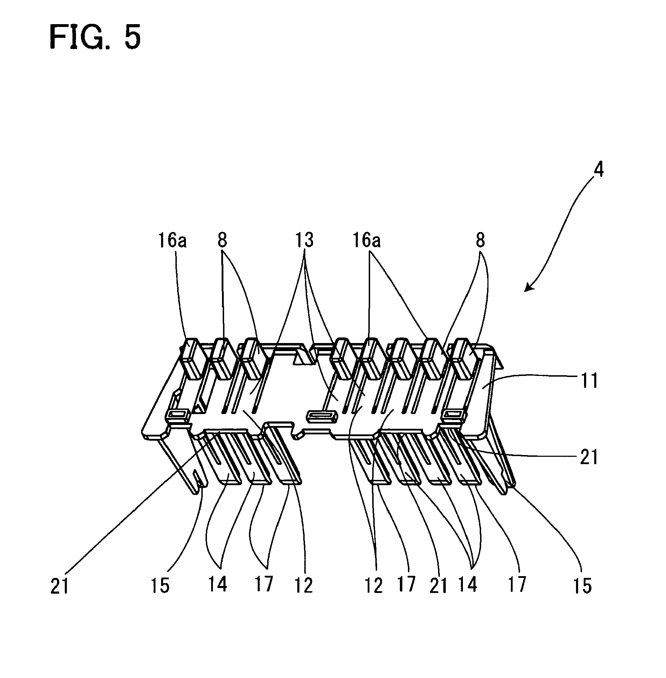

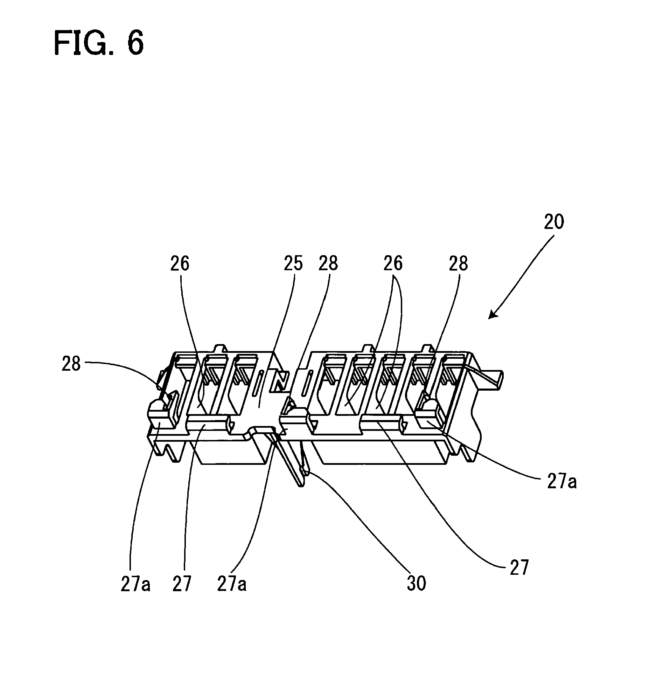

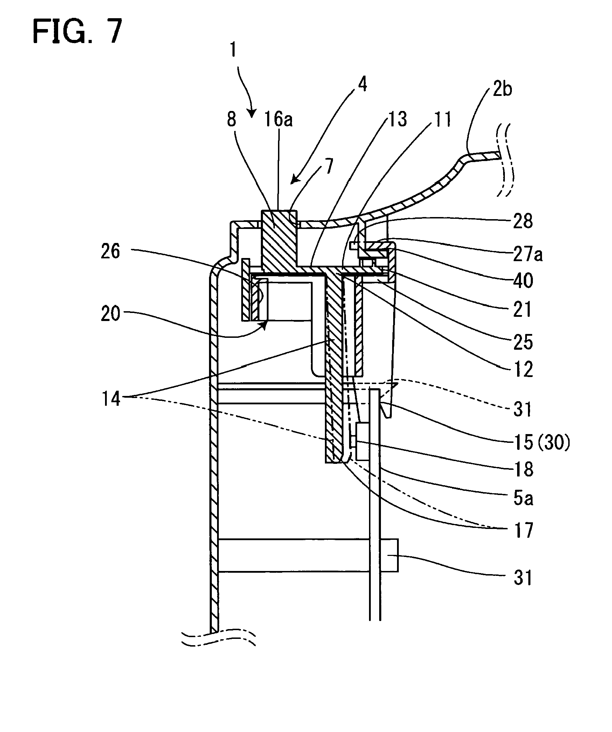

Next, the button portion 4 and a fixing unit 20 which is used to fix the button portion 4 to the back cabinet 2b will be described. FIG. 4 is a perspective view which shows an operation portion where the button portion and the fixing unit are integrated. FIG. 5 is a perspective view which shows the button portion. FIG. 6 is a perspective view which shows the fixing unit. FIG. 7 is an enlarged cross sectional view which shows a main portion of the display device.

As shown in FIGS. 4-7, the button portion 4 is mounted in such a manner that the button 8 protrudes to the outer side of the upper portion of the housing 2 from the through hole 7 which is formed at the back cabinet 2b as described above. The whole of the button portion 4 is made of a synthesis resin. The button portion 4 is integrally constructed of a frame portion 11 having a flat plate shape, a hinge portion 13 which tilts with a fulcrum portion 12 as a fulcrum, the button 8 which is arranged at the top of the hinge portion 13, an operation protrusion portion 14 which is integrally arranged near the fulcrum portion 12 of the hinge portion 13, a circuit board engagement slit 15 which is a guide groove for clipping a power circuit board 5a which will be described later, and the like. As shown in FIG. 7, in the state where the button portion 4 is attached to the back cabinet 2b, a tip portion 16a of the button 8 can be pressed by a finger or the like to be manually operated so that a switch contact portion 17 of the operation protrusion portion 14 which is positioned at the opposite side of the tip portion 16a tilts with the fulcrum portion 12 as the fulcrum, and the switch contact portion 17 of the operation protrusion portion 14 presses a switch 18 which is mounted at the power circuit board 5a so that a ON/OFF switching operation of the switch 18 is interlockingly made.

Moreover, a plurality of concave portions 21 for an integral attachment to the fixing unit 20 are formed with a step shape at a side edge portion of the button portion 4. Button-fixing locking nails 27 (which will be described later) which are formed at the fixing unit 20 are engaged with the above-described concave portion 21, so that the button portion 4 and the fixing unit 20 are position-determined and integrated to each other. Thus, the operation portion 10 which is constructed of the button portion 4 and the fixing unit 20 is integrally formed.

Next, the structure of the fixing unit 20 will be described. The fixing unit 20 is used to fix the button portion 4 to the back cabinet 2b, and the whole of the fixing unit 20 is made of synthesis resin like the button portion 4 as described above. The fixing unit 20 is integrally constructed of a housing 25 which contacts the frame portion 11 of the button portion 4, a button housing hole 26 which is formed corresponding to the number of the operation protrusion portions 14 of the button portion 4, the button-fixing locking nail 27 which has a L-like shape and is engaged with the concave portion 21 (having the step shape) of the button portion 4, a cabinet-fixing locking nail 27a which has a L-like shape and formed integrally to the housing 25, a locking stopper 28 of a hook shape which is formed integrally to a side portion of the cabinet-fixing locking nail 27a, a circuit board engagement slit 30 which is a guide groove for clipping the power circuit board 5a and the like.

Next, the circuit boards 5a - 5c which are mounted in the back cabinet 2b will be described. The above-described power circuit board 5a constructs a circuit of the power system of the display device 1. The power circuit board 5a is caught by the circuit board engagement slit 15 and the circuit board engagement slit 30 which are formed at the button portion 4 and the fixing unit 20, and multiple first circuit board locking nails 31 which are formed at the back cabinet 2b are locked to the edge portion of the power circuit board 5a. Thus, the power circuit board 5a is strongly fixed to the back cabinet 2b (that is, the state shown in FIG. 7). The circuit board engagement slit 15 and the circuit board engagement slit 30 which are guide grooves extend to the rear side of the operation portion 10 to be formed.

The main circuit board 5b constructs a circuit for proceeding a control process of the whole of the display device 1. A second circuit board locking nail 32 which is a holding unit (locking unit) formed at the back cabinet 2b is locked to an edge portion of the main circuit board 5b, so that the main circuit board 5b is strongly fixed to the back cabinet 2b.

The light receiving board 5c where a light receiving portion is arranged constructs a circuit which proceeds a control process of an operation such as a channel switching of the display device 1 based on signals which are sent from a remote control (not shown) for remotely operating the display device 1. The edge portion of the light receiving board 5c is locked to be fixed to a light-receiving board locking nail 33 which is a locking unit formed at a speaker holder (holder) 34 fixed to the back cabinet 2b. Various electron members such as CPU which is a control unit and the like are mounted at the circuit boards 5a, 5b and 5c, and the specification thereof is omitted (because it is not a purport of the present invention).

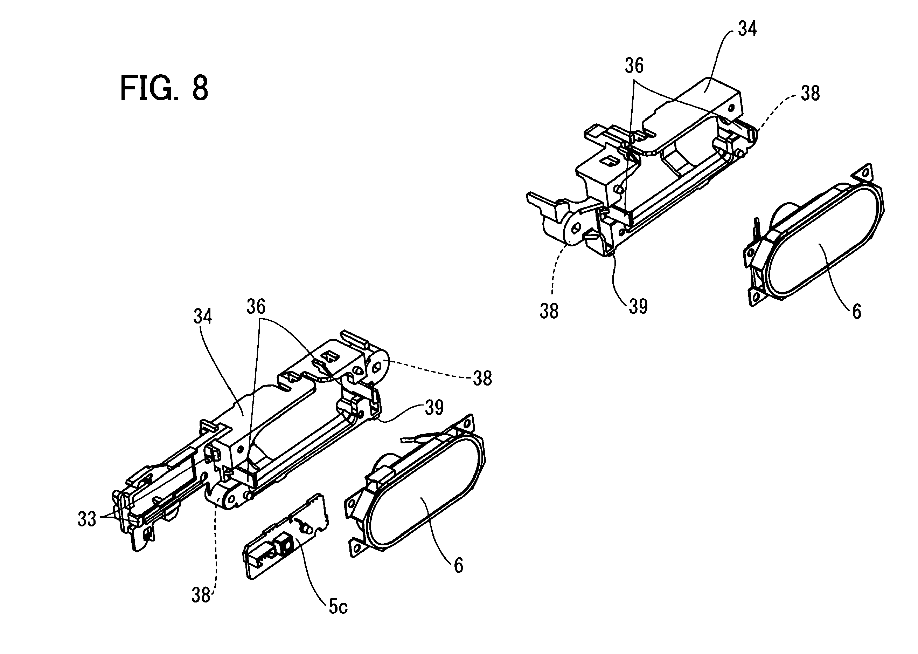

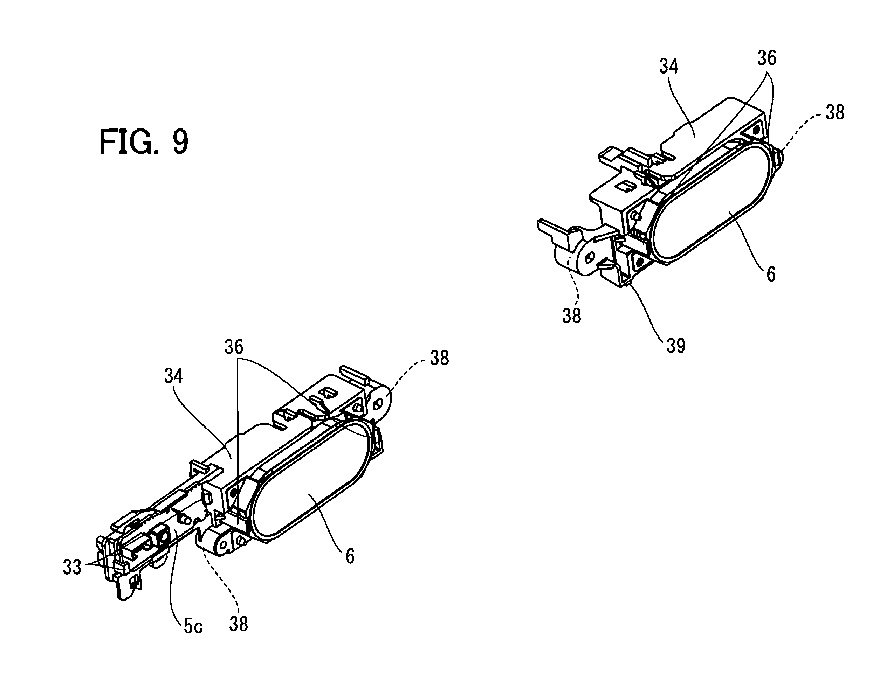

Next, a pair of speakers 6 for outputting sound corresponding to the image which is displayed at the liquid crystal panel 3 (display panel) will be described with reference to FIGS. 8 and 9. FIG. 8 is an exploded perspective view which shows the speaker and the speaker holder to which the speaker is attached. FIG. 9 is a perspective view which shows a state where the speaker is attached to the speaker holder. The speaker 6 which is shown is held (fixed) at the back cabinet 2b through the speaker holder 34. Each of the left portion and the right portion of the each speaker 6 is fixed by a pair of speaker locking nails 36. That is, the two pairs of speaker locking nails 36 are respectively arranged at the speaker holder 34. That is, in addition to the light-receiving board locking nail 33 for fixing the light receiving board 5c having been described above, a unit for locking the speaker 6 is provided at the speaker holder 34.

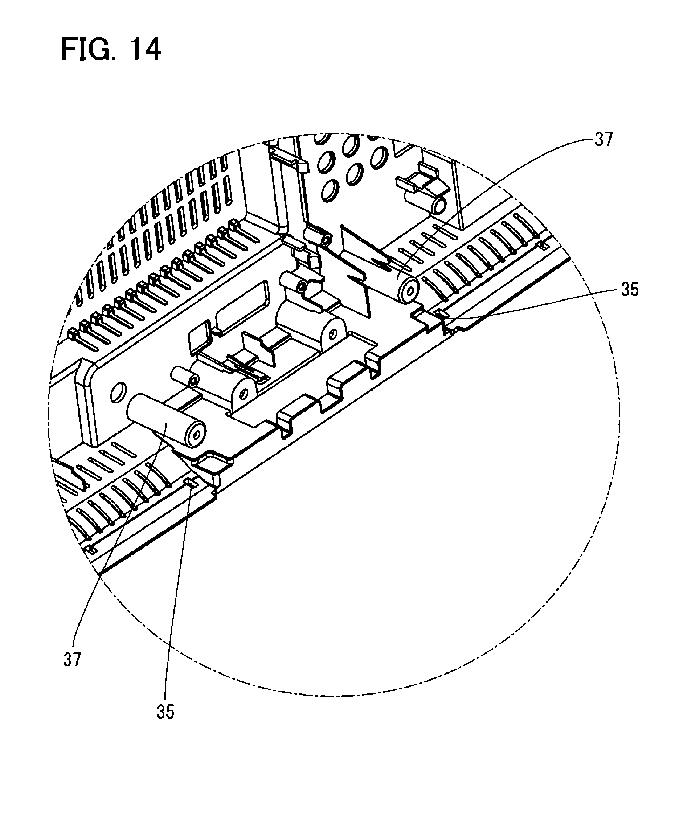

Moreover, a cylinder hole 38 engaged with a boss portion 37 which has a substantially cylinder shape and is formed integrally to the back cabinet 2b is formed at the speaker holder 34. The cylinder hole 38 is inserted through the boss portion 37 so that the speaker holder 34 is held at the back cabinet 2b. As shown in FIG. 14, the boss portion 37 extends to the side of the opening portion of the back cabinet 2b from the inner surface side of the back cabinet 2b. Furthermore, an engagement hole 35 is formed at the edge portion (which is near the boss portion 37) of the opening portion of the back cabinet 2b. A nail portion 39 which is formed at the speaker holder 34 is engaged with the engagement hole 35, and the boss portion 37 of the back cabinet 2b is engaged with the cylinder hole 38 which is formed at the speaker holder 34. Thus, the speaker holder 34 is fixed to the back cabinet 2b.

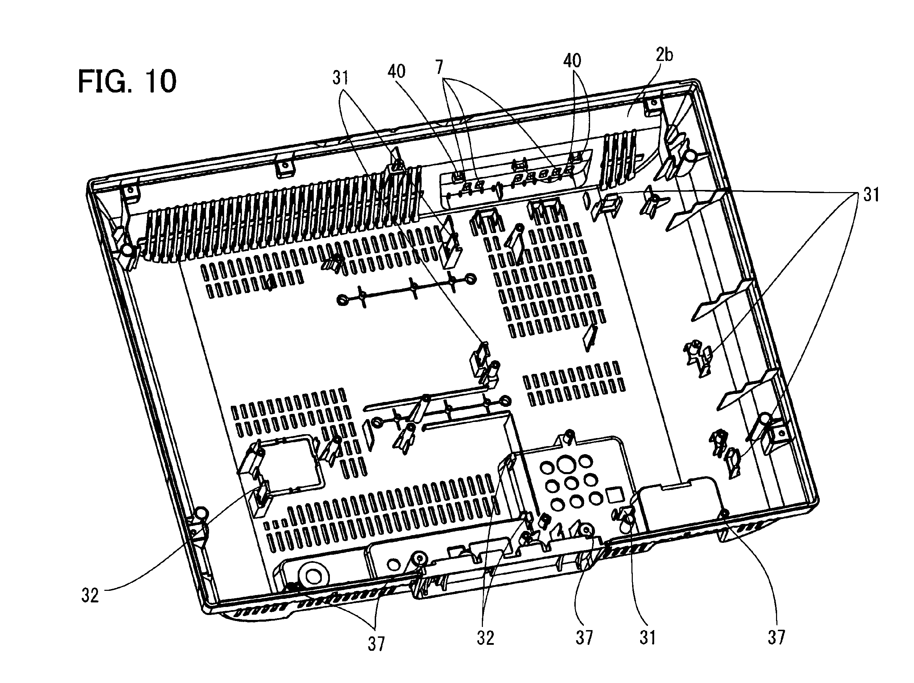

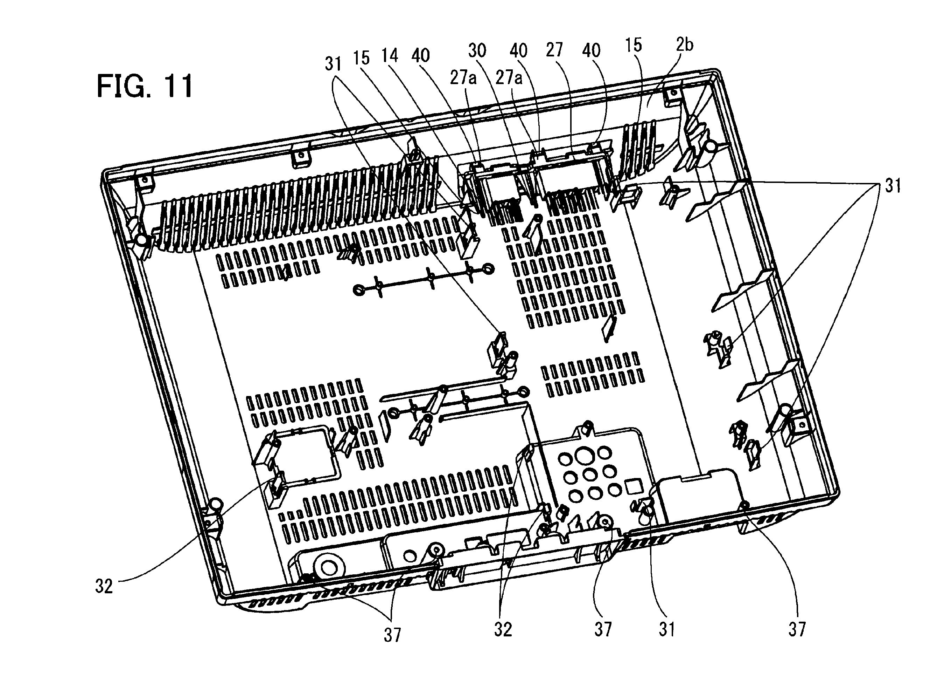

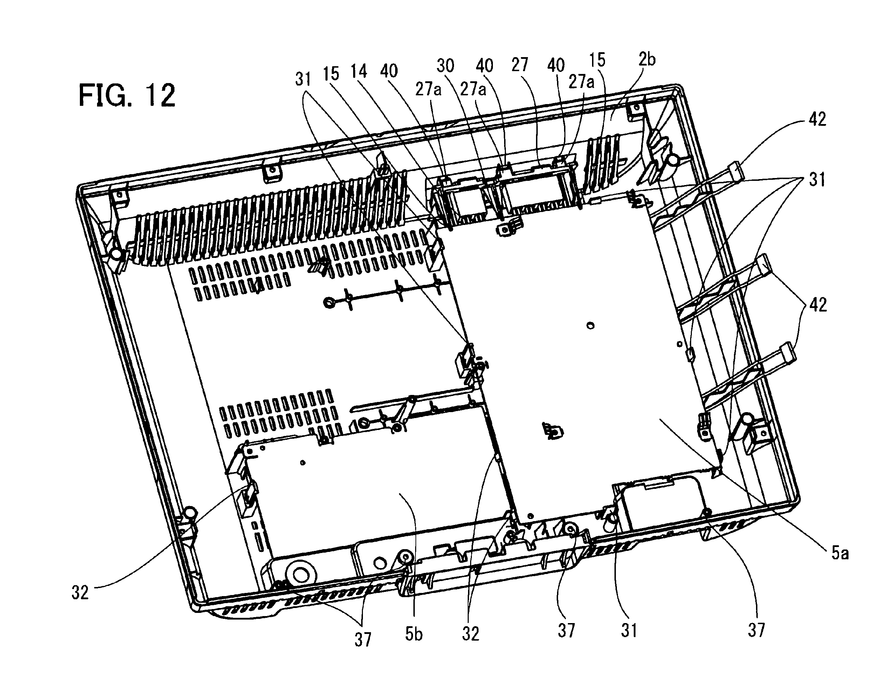

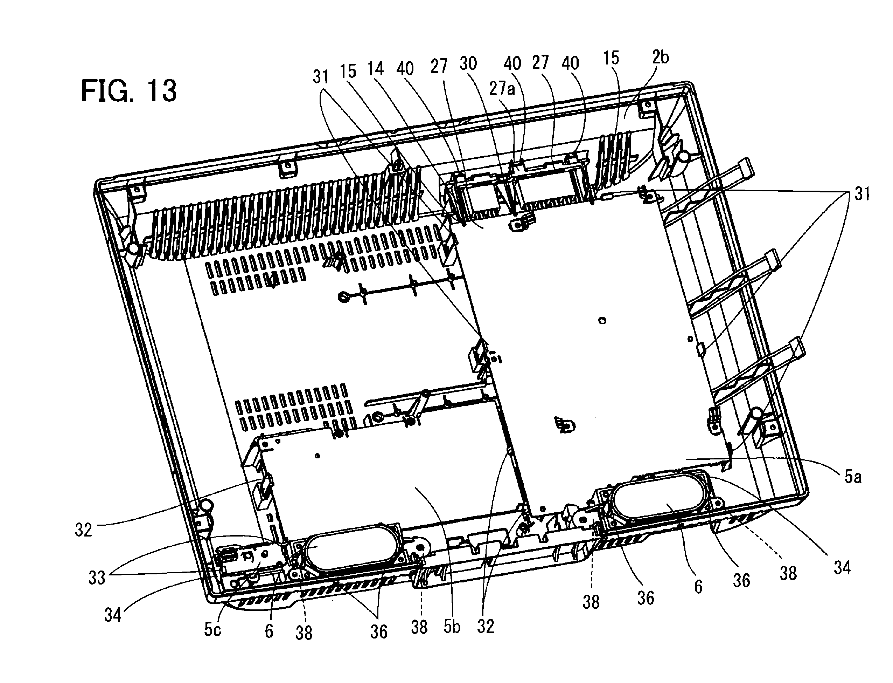

Next, the sequence of the attachment of the button portion 4, the circuit boards 5a-5c, and the speaker 6 (which are main members of the display device 1) to the back cabinet 2b will be described with reference to the drawings. FIG. 10 is a perspective view which only shows the back cabinet. FIG. 11 is a perspective view which shows a state where the button portion is attached to the back cabinet by the fixing unit. FIG. 12 is a perspective view which shows a state where the circuit board is attached to the back cabinet. FIG. 13 is a perspective view which shows a state where the speaker is attached to the back cabinet.

At first, in order to integrate the button portion 4 and the fixing unit 20 shown in FIGS. 5 and 6, the button 8 of the button portion 4 is inserted through the button housing hole 26 of the fixing unit 20 and the button-fixing locking nails 27 of the fixing unit 20 is engaged with the concave portion 21 of the button portion 4 in such a manner that the frame portion 11 of the button portion 4 and the housing 25 of the fixing unit 20 are contacted with each other. Thus, the fixing unit 20 and the button portion 4 are integrated as shown in FIG. 4.

Subsequently, in order to fix the button portion 4 to the back cabinet 2b shown in FIG. 10, the cabinet-fixing locking nail 27a which is a locking unit of the fixing unit 20 is engaged with an operation portion locking nail 40 formed at the back cabinet 2b, and the locking stopper 28 which is formed at a side portion of the cabinet-fixing locking nail 27a is engaged with one end of the back cabinet 2b which forms the operation portion locking nail 40. Thus, the button portion 4 is fixed to the back cabinet 2b by using the fixing unit 20 (that is, the state shown in FIG. 11).

Next, as shown in FIG. 12, one end of the power circuit board 5a is caught by the circuit board engagement slits 15 and 30 which are the guide grooves arranged at the button portion 4 and the fixing unit 20. Moreover, the other end of the power circuit board 5a is locked by the first circuit board locking nail 31 which is formed at the back cabinet 2b. The power circuit board 5a is fixed to the button portion 4 in the back cabinet 2b. Subsequently, the edge portion of the main circuit board 5b is locked to the second circuit board locking nail 32 which is formed at the back cabinet 2b, so that the main circuit board 5b is also fixed in the back cabinet 2b.

Next, the edge portion of the light receiving board 5c is locked to the light-receiving board locking nail 33 of the speaker holder 34 to be fixed, and the speaker 6 is locked to the speaker locking nail 36 to be fixed. The boss portion 37 which is formed at the back cabinet 2b is inserted through the cylinder hole 38 which is formed at the speaker holder 34 (by which the light receiving board 5c and the speaker 6 are fixed) to be engaged, and the speaker holder 34 where the light receiving board 5c and the speaker 6 are fixed is fixed to the back cabinet 2b (that is, the state shown in FIG. 13).

Next, as shown in FIG. 3, after a shield member 41 is fixed at a predetermined position of the back cabinet 2b, a connection cable 42 is connected with a predetermined position of the liquid crystal panel 3. Moreover, the liquid crystal panel 3 is fixed at a position which faces the shield member 41, the power circuit board 5a and the main circuit board 5b (that is, the state shown in FIG. 2), and the front cabinet 2a is integrated with the back cabinet 2b. Thus, the assembling process of the display device 1 is performed.

According to the display device 1 of the present embodiment, the display panel is provided in the housing which has the relatively small depth in comparison with the height and the width thereof, and the housing 2 is provided with the operation portion 10 where one portion protrudes to the outer side of the device from the multiple through holes 7. The first holding unit (the circuit board engagement slit 15, 30 which is the guide groove) for holding the one end (the one side among the four sides of the power circuit board 5a which has a rectangle shape, for example) of the circuit board (the power circuit board 5a) of the rectangle shape is provided at the operation portion 10, and the second holding unit (the first circuit board locking nail 31) which holds the other end (the three sides except the above-described one side) of the circuit board (the power circuit board 5a) is formed at the housing 2. The circuit board (the power circuit board 5a) which is held by the first holding unit (the circuit board engagement slit 15, 30 which is the guide groove) and the second holding unit (the first circuit board locking nail 31) is held substantially parallel to the display panel (the liquid crystal panel 3). The operation portion 10 is constructed of the button portion 4 where the pressing portion protruding to the outer side of the device is integrally formed, and the fixing unit 20 where the locking unit (the cabinet-fixing locking nail 27a and the locking stopper 28) by which the button portion 4 is attached to the back cabinet 2b of the housing 2 is formed. The power circuit board 5a is caught by the circuit board engagement slit 15 (as the guide groove of the operation portion 10) of the button portion 4 and the circuit board engagement slit 30 of the fixing unit 20, and the power circuit board 5a is held by the first circuit board locking nail 31 as the second holding unit which is formed at the housing 2. Accordingly, the circuit board (the power circuit board 5a) where the switch 18 and the like are arranged can be held at the predetermined position by the first holding unit (the circuit board engagement slit 15, 30 which is the guide groove) of the operation portion 10 and the second holding unit (the first circuit board locking nail 31) which is arranged at the back cabinet 2b of the housing 2, so that the circuit board (the power circuit board 5a) can be fixed without using screws conventionally. Thus, when the inner construction member which is the main member of the display device 1 is assembled to the back cabinet 2b, by using the holding unit and the locking unit (holding unit) (being not a fixing by the screw), the inner construction members such as the speaker 6, the light receiving board 5c, the power circuit board 5a and the like can be fixed without using the screw. Therefore, the troublesome screw-fitting operation can be relieved. Moreover, because the screw made of the metal is not used, the cost due to the use of the metal material can be reduced. Furthermore, because the operation for screwing the screw is unnecessary, the time spent in assembling the inner construction members to the display device 1 can be shortened. Thus, the manufacture efficiency can be improved.

Furthermore, the second holding unit is the single first circuit board locking nail 31 or the multiple first circuit board locking nails 31 extending from the inner surface side of the back cabinet to the opening portion thereof to be formed, and the other end of the power circuit board 5a which is the circuit board is locked by the first circuit board locking nail 31. Accordingly, the power circuit board 5a can be locked to be held by the first circuit board locking nail 31 as the second holding unit which is formed at the housing 2, in such a manner that the power circuit board 5a is clipped by the guide groove (the circuit board engagement slit 15, 30) as the first holding unit of the operation portion 10. Therefore, the power circuit board 5a can be readily fixed only by the holding unit without using the screw.

Furthermore, because the speaker 6 and the light receiving board 5c as the inner construction members are held by a third holding unit (the speaker holder 34) where the screw is not used, the speaker 6 and the light receiving board 5c can be fixed at the predetermined position in the back cabinet without using the screw.

Furthermore, the third holding unit is the speaker holder 34 which is provided with the locking unit (the light-receiving board locking nail 33, the speaker locking nail 36) for locking the speaker 6 and the light receiving board 5c (the inner construction members). The boss portion 37 which extends form the inner surface side to the side of the opening portion of the back cabinet 2b is formed at the back cabinet 2b, and the engagement hole 35 is formed at the edge portion (near the boss portion 37) of the opening portion of the back cabinet 2b. The cylinder hole 38 where the boss portion 37 is engaged and the nail portion 39 which is engaged with the engagement hole 35 are formed at the speaker holder 34. Thus, the inner construction members such as the speaker 6, the light receiving board 5c and the like are locked by the speaker holder 34 as the third holding unit, and the cylinder hole 38 of the speaker holder 34 is engaged with the boss portion 37 of the back cabinet 2b. The nail portion 39 which is formed at the speaker holder 34 is engaged with the engagement hole 35 of the back cabinet 2b. Therefore, the speaker 6 and the light receiving board 5c which are the inner construction members can be held (fixed) at the back cabinet 2b through the speaker holder 34 without using the screw.

Moreover, in other word, the display device 1 is constructed in such a manner that the inner construction members as the main members of the display device 1, that is, all of the button portion 4, the speaker 6 and the circuit board (the power circuit board 5a, the main circuit board 5b, and the light receiving board 5c) can be fixed only by the holding unit (fixing unit) and the locking unit which is constructed at the holding unit or the like without using the screw made of the metal. The button portion 4 is fixed at the back cabinet 2b by using the cabinet-fixing locking nail 27a, the locking stopper 28 and the like (as locking unit) which are provided at the fixing unit 20 (being the separate holding unit from the button portion 4). The edge portion of the power circuit board 5a where the switch 18 is arranged is clipped with respect to only the circuit board engagement slit 30 of the fixing unit 20 or with respect to the circuit board engagement slit 30, 15 formed at the fixing unit 20 and the button portion 4, and the power circuit board 5a and the button portion 4 are fixed in the housing 2 (specifically, in the back cabinet 2b) without using the screw. Furthermore, the fixing unit 20 (specifically, the circuit board engagement slit 30 of the fixing unit 20) which is aimed to fix the button portion 4 to the back cabinet 2b, or additionally the button portion 4 which is aimed to manually operate the display device 1 are used also as a unit for holding (fixing) the power circuit board 5a. Accordingly, the fixing of the power circuit board 5a and the button portion 4 can be readily performed only by locking, without using the screw conventionally. Thus, the troublesome operation where the screws are fitted one by one can be untied. Moreover, because the screw made of the metal is not used, the cost because of the use of the metal material can be reduced.

Moreover, the edge portion of the power circuit board 5a is clipped at the circuit board engagement slit 15, 30 formed at the fixing unit 20 and the button portion 4, and the edge portion of the power circuit board 5a is locked at the first circuit board locking nail 31 which is the holding unit (locking unit) formed integrally to the back cabinet 2b. When the power circuit board 5a is fixed in the housing 2, the power circuit board 5a, the fixing unit 20 and the button portion 4 are integrally combined to each other so that the power circuit board 5a, the fixing unit 20 and the button portion 4 can be held in a position-determined state without an offset or the like to each other.

Moreover, the speaker 6 which can output the sound corresponding to the image which is displayed by the liquid crystal panel 3 attached at the side of the back cabinet 2b of the display device 1 can be fixed only by locking (without using the screw) to the speaker locking nail 36 which is the locking unit of the speaker holder 34 arranged in the housing 2. Therefore, the attachment of the speaker 6 can be easily performed by a one-touch feeling. Thus, the efficiency of the assembling working can be improved so that the manufacture efficiency of the display device 1 can be improved.

As described above, the embodiment of the present invention is specifically described. However, the present invention is not limited to the above-described embodiment. Various modification embodiments are available in the range of the purport of the present invention. For example, the display device 1 can be also constructed of a plasma television receiver or an organic EL television receiver or the like (needless to say, the liquid crystal display device or a plasma display device). Moreover, in this embodiment, the structure where the fixing of the circuit boards 5a - 5c, the speaker 6 and the like is performed without using the screw is provided. However, in the case where an electron member having a relatively large weight is mounted at the circuit boards 5a - 5c or in the case where a speaker or the like which is large-sized and heavy is used so as to improve an acoustic effect, the use of the screw (preferably, the screw made of the resin) for the attachment of the circuit board and the speaker in addition to the above-described attachment structure can be also suitable considering the weight. In this case, the circuit board and the speaker can be held more strongly.

## Claims

1. A display device which includes a display panel in a housing having a relatively small depth in comparison with a height and a width thereof, the display device comprising:
an operation portion which is arranged at the housing and protrudes from a plurality of through holes to the external;
a first holding unit which is arranged at the operation portion to hold one end of a circuit board; and
a second holding unit which is arranged at the housing to hold the other end of the circuit board, wherein
the circuit board which is held by the first holding unit and the second holding unit is substantially parallel to the display panel.

2. The display device according to claim 1, wherein the housing is constructed by fitting an opening portion which is provided at a front cabinet and an opening portion which is provided at a back cabinet respectively.

3. The display device according to claim 1 or 2, wherein the circuit board is provided with a switch which interlocks with a press operation of the operation portion at least.

4. The display device according to any one of claims 1-3, wherein the operation portion is constructed of a button portion where a pressing portion protruding to the external is integrally formed, and a fixing unit where a locking unit for fitting the button portion to the back cabinet is formed.

5. The display device according to any one of claims 1-4, wherein the first holding unit is a guide groove which extends to a rear side of the operation portion to be formed, and the one end of the circuit board is clipped by the guide groove.

6. The display device according to any one of claims 1-5, wherein the second holding unit is constructed of a single circuit board locking nail or a plurality of circuit board locking nails which extend from an inner surface side of the back cabinet to the opening portion thereof to be formed, and the other end of the circuit board is locked by the circuit board locking nail.

7. The display device according to any one of claims 1-6, further comprising
a third holding unit for holding an inner construction member at the back cabinet.

8. The display device according to claim 7, wherein the inner construction member includes a speaker and a light receiving board.

9. The display device according to claim 7 or 8, wherein:
the third holding unit is a holder for locking the inner construction member;
a boss portion which extends from the inner surface side to a side of the opening portion is formed at the back cabinet;
an engagement hole is formed at an edge portion of the back cabinet which is in the vicinity of the boss portion; and
a cylinder hole where the boss portion is engaged and a nail portion which is engaged with the engagement hole are formed at the holder.
